(19) Europäisches Patentamt
European Patent Office
Office européen des brevets

(11) **EP 1 643 546 A2**

(12) **EUROPEAN PATENT APPLICATION**

(43) Date of publication:
**05.04.2006 Bulletin 2006/14**

(51) Int Cl.:
**H01L 21/316** (2006.01)

(21) Application number: **05255966.3**

(22) Date of filing: **26.09.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **01.10.2004 JP 2004290051**

(71) Applicant: **CANON KABUSHIKI KAISHA Ohta-ku, Tokyo (JP)**

(72) Inventors:
• **Matsuo, Yasuhiro c/o Canon Kabushiki Kaisha Tokyo (JP)**

• **Ishibe, Yoshihiro c/o Canon Kabushiki Kaisha Tokyo (JP)**
• **Kimura, Kazumi c/o Canon Kabushiki Kaisha Tokyo (JP)**
• **Nomura, Kentarou c/o Canon Kabushiki Kaisha Tokyo (JP)**

(74) Representative: **Legg, Cyrus James Grahame et al ABEL & IMRAY, 20 Red Lion Street London WC1R 4PQ (GB)**

(54) **Method for manufacturing a nanostructure**

(57)   A method for manufacturing a nanostructure is provided, in which pores (3) having diameters on the order of nanometers (nm), the diameter decreasing as in a tapered shape, can be manufactured. The method includes repeated cycles of the alternate step of anodizing Al or an Al alloy (1) to form an anodic oxide film (2) having pores (3) in an anodizing step and increasing diameter of the pore (3) in a pore-widening step, so that the diameter of the pore (3) is varied in the depth direction.

FIG. 1A

(ANODIZING STEP)

FIG. 1B

(PORE-WIDENING STEP)

FIG. 1C

(ANODIZING STEP)

FIG. 1D

**Description**

BACKGROUND OF THE INVENTION

Field of the Invention

The present invention relates to a method for manufacturing a microstructure (nanostructure) having a periodic structure of a few tens of nanometers to a few hundred nanometers, and is suitable for manufacturing elements related to electronics, biology, and optics.

The present invention also relates to a fine structure grating produced by using the nanostructure.

Furthermore, the fine structure grating of the present invention may be disposed on a surface of a scanning lens used in an optical scanning apparatus, and has an antireflective function.

Description of the Related Art

Thin films, thin lines, dots, and the like of metals and semiconductors having sizes smaller than a specific length may exhibit unique electric, optical, and chemical properties.

From this point of view, there has been a growing interest in a structure (microstructure) on the order of nanometers as a functional material, the microstructure having a structure finer than 1 micrometer ($\mu$m).

A typical method for manufacturing the microstructure on the order of nanometers is, for example, a semiconductor manufacturing process by using photolithography. However, there are many problems in compatibility between an increase in area and a reduction in manufacturing cost.

A technique of so-called self-organization based on a naturally formed regular structure has attracted attention as a technology for ensuring the compatibility between an increase in area and a reduction in manufacturing cost, and considerable research has been conducted. Examples of techniques of self-organization include anodization of Al (refer to R. C. Furneaux, W. R. Rigby & A. P. Davidson, NATURE, Vol. 337, P147, (1989)).

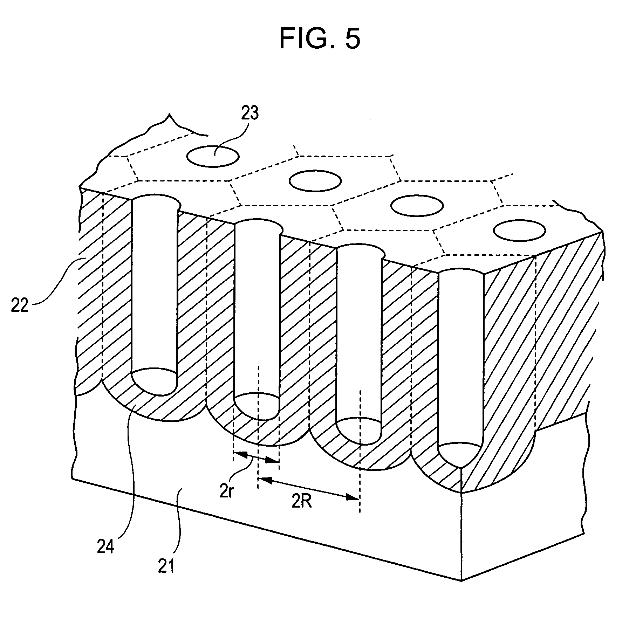

Fig. 5 is a diagram showing an anodic oxide film having cylindrical pores (nanoholes). As shown in the drawing, when an Al plate 21 is anodized in an acidic electrolyte, an anodic oxide film 22 having pores 23 is formed.

These pores 23 are characterized by being very fine cylindrical pores of a few tens of nanometers to a few hundred nanometers in diameter and having a specific geometric structure in which the pores are arranged in parallel at intervals of a few tens of nanometers to a few hundred nanometers.

These cylindrical pores 23 have large aspect ratios and the diameter of the cross-section is highly uniform. The diameters and the intervals of these pores 23 can be controlled to some extent by adjusting the current and the voltage during anodization.

Various proposals have been attempted in consideration of this specific geometric structure of the Al anodic oxide film (refer to Masuda, KOTAI BUTSURI (Solid State Physics), Vol. 31, 493, (1996)). Examples of applications will be described below, while detailed explanations have been made in the above-described document by Masuda.

Examples thereof include an application to films taking advantage of the abrasion resistance and the insulating property of the anodic oxide film.

Various applications to coloring, magnetic recording media, EL light emitting elements, electrochromic elements, optical elements, solar cells, gas sensors, and others are attempted by the use of a technology for filling a metal, semiconductors, and the like in nanoholes and a technology for replicating nanoholes.

Furthermore, applications to many areas, for example, quantum effect devices, e.g., quantum wires and MIM elements, and molecular sensors through the use of nanoholes as chemical reaction fields, are expected.

On the other hand, the technique of self-organization, in particular the technique of Al anodization, has an advantage that the microstructure on the order of nanometers can easily be formed with good controllability.

According to this technique, in general, a nanostructure having a large area can be formed. Various proposals for the use of this technique have been made previously (refer to Japanese Patent Laid-Open No. 63-187415 and Japanese Patent Laid-Open No. 11-200090).

Japanese Patent Laid-Open No. 63-187415 discloses a magnetic recording medium in which an electrochemically stable substrate layer having electrical conductivity is laminated on a base material, an anodic oxide film of Al or an Al alloy is laminated on the substrate layer, and magnetic materials are filled in micropores disposed in the anodic oxide film.

Here, a material, e.g., Rh, Nb, Ta, Au, Ir, Pt, Ti, Cr, Pd, Ru, Os, Ga, Zr, Ag, Sn, Cu, Hf, or Be, is used as the substrate layer.

It is described that the use of the above-described 18 types of material exhibits an effect of making the depths of micropores formed in the anodic oxide film during anodization of Al or the Al alloy uniform.

Japanese Patent Laid-Open No. 11-200090 describes the formation of electrically conductive paths on the bottoms of pores and, thereby, the pores are formed uniformly while the bottoms of pores have excellent electrical conductivity.

The pore on the order of nanometers produced by Al anodization has a pore diameter (minor axis) exhibiting excellent uniformity in the depth direction (major axis).

Various applications are able to take advantage of the above-described advantageous features. However, in some cases related to electronics, biology, and optics, it is desirable that the pores have a nonuniform diameter.

For example, in the case where pores are used as mother dies and transferred members are used as optical elements, periodic structures on the order of nanometers may perform an antireflective function, and particularly excellent antireflective properties may be exhibited in the case that the transferred member is in the shape of a circular cone rather than a cylinder.

## SUMMARY OF THE INVENTION

The present invention provides a method for manufacturing a microstructure, in which pores having pore diameters on the order of nanometers and decreasing in a tapered shape can be manufactured.

A method for manufacturing a nanostructure according to an aspect of the present invention includes a) an anodizing step of anodizing Al or an Al alloy to form an anodic oxide film having first pores, b) an increasing step of increasing diameters of the first pores in the anodic oxide film, and c) an anodizing step of anodizing the anodic oxide film to form a second pore at the bottom of each first pore, wherein the second pores have different diameters to the first pores.

Further features of the present invention will become apparent from the following description of exemplary embodiments with reference to the attached drawings.

## BRIEF DESCRIPTION OF THE DRAWINGS

Figs. 1A to 1D are diagrams showing steps according to a first embodiment of the present invention.

Figs. 2A to 2C are diagrams schematically showing cross-sections of pores according to the first embodiment of the present invention.

Fig. 3 is a diagram showing an outline of an anodization apparatus according to the first embodiment of the present invention.

Fig. 4 is a diagram showing an outline of a pore-widening apparatus according to the first embodiment of the present invention.

Fig. 5 is a diagram showing an anodic oxide film having pores known from the prior art.

Fig. 6 is a sectional view showing a main scanning cross-section of an optical scanning apparatus according to a second embodiment of the present invention.

## DESCRIPTION OF THE EMBODIMENTS

The definition of a fine structure grating in the present invention will be described below.

For a fine structure grating, a lattice pitch P that satisfies a condition for a so-called zero-order lattice is selected. The fine structure grating is referred to as an SWS (subwave structure).

The lattice pitch is less than or equal to the order of the wavelength of a light source to be used (on the order of nanometers), and the fine structure grating is designed to be used for zeroth-order light having no diffraction effect (refer to US Patent Application No. 20020179827 A1).

A zero-order lattice is a lattice that produces no diffracted light other than zeroth-order light in a periodic fine structure grating.

In a periodic fine structure grating, diffraction light is generally produced at a diffraction angle that satisfies the following conditional expression for diffraction:

$$P(Ns \cdot \sin\theta m - Ni \cdot \sin\theta i) = m\lambda \qquad (a)$$

where P is a lattice pitch, Ni is a refractive index (of a medium of the fine structure grating) on an incident side, $\theta i$ is an incident angle, $\theta m$ is an m-order diffraction angle, Ns is a refractive index (of the medium of the fine structure grating) on an exit side, m is a diffraction order, and $\lambda$ is an operating wavelength. As is obvious from the equation (a), with respect to the diffraction angle, $\theta m \geq \theta 1$ (m = 1) holds.

In the case of normal incidence, the condition under which no +1st-order diffracted light is produced is defined as

$$\theta_{+1} \geq 90° \qquad (b)$$

and, therefore, it is clear that

$$P < \lambda/(Ns + Ni \cdot \sin\theta i) \qquad (c)$$

is the condition for a zero-order lattice.

$\theta_{+1}$ becomes 90 degrees or more at the most off-axis position, and hence the lattice pitch P becomes a smaller Pa. When the incident angle is other than 0 degrees, the lattice pitch P must be further reduced.

The embodiments of the present invention will be described below with reference to the drawings.

FIRST EMBODIMENT

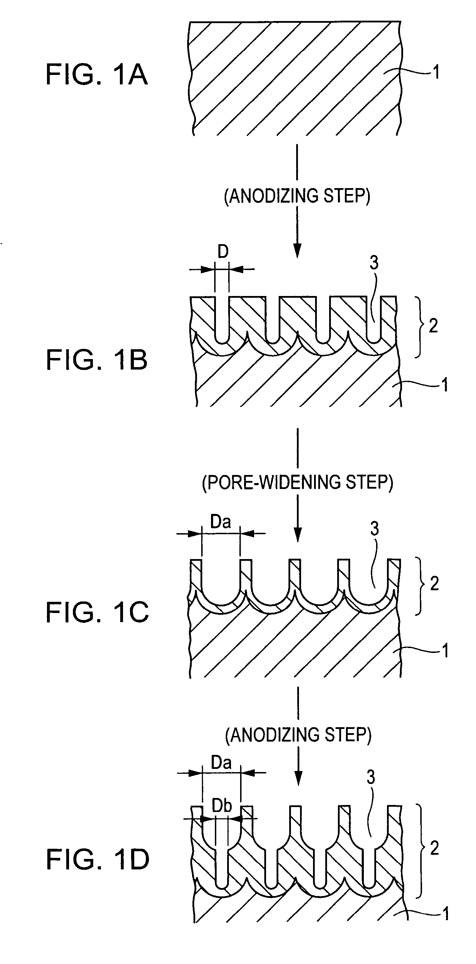

Figs. 1A to 1D are explanatory diagrams showing an outline of the steps of a process for manufacturing a microstructure (nanostructure) according to the first embodiment of the present invention.

In the drawings, reference numeral 1 denotes aluminum (Al) or an Al alloy, reference numeral 2 denotes an anodic oxide film, and reference numeral 3 denotes a pore.

In the present embodiment, when Al or an Al alloy 1 is anodized in the anodizing step (the first step), an anodic oxide film 2 including pores 3 having a relatively small pore diameter D is formed in accordance with the conditions (composition, temperature, and applied voltage of an acidic electrolytic solution) for anodization (Fig. 1B).

The pore diameter (thickness) D of the pore 3 is increased to a pore diameter Da in the pore-widening step (the second step) in accordance with the conditions (composition, temperature, and treatment time of an etching solution) for pore-widening (Fig. 1C).

In another anodizing step (the third step), another pore having a pore diameter of Db is further formed at the bottom of the pore having the pore diameter of Da.

Consequently, a pore 3 is formed which consists of a pore having a small diameter Db stepwise disposed at the bottom of the pore having a large diameter Da (Fig. 1D).

The anodizing step of the present embodiment is a step in which Al or an Al alloy is immersed as an anode in an acidic electrolytic solution, a cathode is similarly immersed, and a direct-current power supply is connected between the anode and the cathode to supply power, so that Al or the Al alloy is oxidized and pores are self-organized by one operation to form an anodic oxide film.

The pore diameters of the above-described pores are on the order of nanometers. The above-described acidic electrolytic solution is a solution containing at least one of sulfuric acid, oxalic acid, and phosphoric acid.

At this time, intervals between the pores can be controlled to some extent at a few tens of nanometers to a few hundred nanometers by appropriately selecting the composition, the temperature, and the applied voltage of the acidic electrolytic solution, and the depths of the pores can be controlled to some extent by the application time.

The pore-widening step is a step in which the anodic oxide film provided with pores is immersed in an etching solution that is an acidic or alkaline solution and, thereby, side walls of the pores are dissolved, so as to increase the pore diameter.

At this time, the pore diameters can be controlled to some extent by adjusting the composition, the temperature, and the treatment time of the etching solution.

In the present embodiment, the anodic oxide film formed through the anodizing step and the pore-widening step is anodized again, so that another pore is further formed at the bottom of the pore having the pore diameter increased by the pore-widening.

That is, the anodizing step and the pore-widening step are performed alternately and, thereby, pores having different dissolution histories are formed while being stacked in a direction of the depth of the pore. As a result, a pore having a diameter varying, specifically decreasing, in the depth direction is formed.

The diameter of the pore formed through the above-described procedure is decreased stepwise or as in a tapered shape by appropriately selecting the anodizing condition and the pore-widening condition.

Since the pore has a wide mouth, when the pores are used as molds, a different type of material can be filled therein with relative ease, and can also be released therefrom with relative ease.

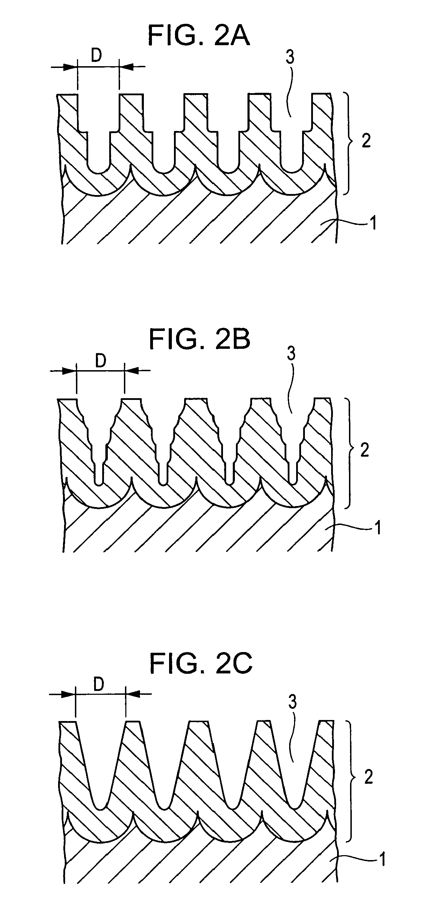

Each of Figs. 2A, 2B, and 2C is a sectional view schematically showing a key portion of a microstructure according to the first embodiment of the present invention.

Fig. 2A shows cross-sections of pores 3 formed in the anodic oxide film 2 when the anodizing step and the pore-widening step are repeated alternately twice. The pore 3 has a two-step configuration and the diameter is decreased stepwise in the depth direction.

Fig. 2B shows cross-sections of pores 3 formed when the anodizing step and the pore-widening step are repeated alternately five times. The pore 3 has a five-step configuration and the diameter is decreased stepwise in the depth direction.

Fig. 2C shows cross-sections of pores 3 formed when the anodizing step and the pore-widening step are repeated alternately a plurality of times (the operation time is fragmented adequately).

A pore having a diameter varying smoothly in the depth direction is formed by performing anodization with fragmentary operation times and repeating short-time pore-widening. The pore is in a tapered shape having a diameter decreasing in the depth direction.

Anodizing step

In the anodizing step of the present embodiment, Al or the Al alloy is immersed in the acidic electrolytic solution, and a direct-current voltage is applied between Al or the Al alloy and a cathode.

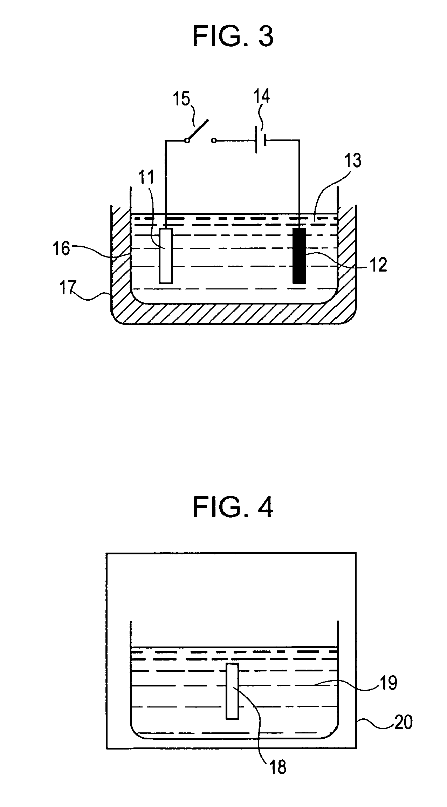

Fig. 3 is a schematic diagram of an anodization apparatus used in the present step. In the drawing, reference numeral 11 denotes a sample made of Al or an Al alloy, reference numeral 12 denotes a cathode, reference numeral 13 denotes an acidic electrolytic solution, reference numeral 14 denotes a direct-current power supply, reference numeral 15 denotes a switch, reference numeral 16 denotes a reaction vessel, and reference numeral 17 denotes a constant-temperature water bath.

In addition, a timer to control the anodization time, an ammeter to monitor the current, circuits to detect the anodization time and the current value and to operate the switch, and the like are incorporated, although not shown in Fig. 3.

In Fig. 3, the sample 11 and the cathode 12 are immersed in the acidic electrolytic solution 13 in the reaction vessel 16, which is kept at a constant temperature by the constant-temperature water bath 17, and the switch 15 is closed for a predetermined time to apply a constant voltage from the direct-current power supply 14, so that anodization is effected.

Examples of acidic electrolytic solutions used for the anodization include phosphoric acid, oxalic acid, and sulfuric acid. The conditions of anodization, that is, the composition, the temperature, the applied voltage, and the application time of the acidic electrolytic solution, are appropriately set in accordance with the intervals and depths of the pores to be produced.

Pore-widening step

In the pore-widening step used in the present embodiment, the pore diameter is increased by dissolving the side wall of the pore formed in the anodic oxide film in the anodizing step.

Fig. 4 is a schematic diagram of a pore-widening apparatus used in the present step. In the drawing, reference numeral 18 denotes a sample having been subjected to the anodizing step, reference numeral 19 denotes an etching solution, and reference numeral 20 denotes a constant-temperature oven.

In addition, a thermometer to detect the surface temperature of the sample, a timer to control the pore-widening time, a handling mechanism to detect the temperature and the pore-widening time and to take out the sample, and the like are incorporated, although not shown in the drawing.

The etching solution used for the pore-widening step is either an acidic solution or an alkaline solution. The conditions of pore-widening, that is, the composition, the treatment time, and the temperature of the etching solution, are appropriately set in accordance with the diameter of the pore to be produced.

In the present invention, since the anodizing step and the pore-widening step must be performed alternately, it is desirable that the acidic electrolytic solution used in the anodizing step and the etching solution used in the pore-widening step are the same type of solution.

For example, it is particularly desirable to use a phosphoric acid solution for both the anodizing step and the pore-widening step.

SPECIFIC EXAMPLES AND COMPARATIVE EXAMPLES

The specific examples and comparative examples of the method for manufacturing a microstructure according to the present embodiment will be described below.

SPECIFIC EXAMPLE 1

A 3-inch Si wafer having a resistance value of 0.01 Ωcm or less was prepared, and an Al film of 500 nm was formed by sputtering. Thereafter, an electrode was fixed to the back, and the electrode, all over the back, and the wafer side surface were covered with an insulating waterproof coating, so that a sample was produced.

The sample was anodized using an anodization apparatus as shown in Fig. 3. The sample was immersed together with a cathode in a 5 percent by weight phosphoric acid aqueous solution controlled at a temperature of 10°C in a constant-temperature water bath. A direct-current power supply was connected, and 120 V was applied for a predetermined time, so that the Al film was anodized by one-half the film thickness.

After the sample was taken out, the surface of the anodic oxide film was viewed with a scanning electron microscope. It was observed that pores were formed at intervals of about 300 nm, and the pore diameter was about 20 nm.

The sample was subjected to pore-widening by using the pore-widening apparatus shown in Fig. 4. The sample was immersed in a 5 percent by weight phosphoric acid aqueous solution controlled at a temperature of 25°C in a constant-temperature oven. After the sample was taken out, the surface of the anodic oxide film was viewed with a scanning electron microscope. It was observed that the pore diameter was about 100 nm.

Anodization was performed again on the same condition by using the anodization apparatus shown in Fig. 3. The sample was immersed together with a cathode in a 5 percent by weight phosphoric acid aqueous solution controlled at a temperature of 10°C in the constant-temperature water bath. A direct-current power supply was connected, and 120 V was applied, so that the Al film was anodized throughout the film thickness.

After the sample was taken out, the surface of the anodic oxide film was viewed with a scanning electron microscope. It was observed that a pore having a pore diameter of about 20 nm was formed at the bottom of the pore having the pore diameter of about 100 nm.

The anodic oxide film was cut perpendicularly with a focused ion beam, and the cross-section was viewed with a scanning electron microscope. It was observed that the cross-sectional shape of the pore was narrowed in two steps in the depth direction as shown in Fig. 2A.

The depth of the pore was 500 nm.

COMPARATIVE EXAMPLE 1

A comparative example relative to the above-described Specific example 1 will be described below.

Each of the anodizing step and the pore-widening step was performed once, and the cross-sectional shape of the pore was observed.

A sample similar to that in the above-described Specific example 1 was prepared, and anodization was performed by using the anodization apparatus shown in Fig. 3. The sample was immersed together with a cathode in a 5 percent by weight phosphoric acid aqueous solution controlled at a temperature of 10°C in a constant-temperature water bath. A direct-current power supply was connected, and 120 V was applied, so that the Al film was anodized throughout the film thickness.

After the sample was taken out, the surface of the anodic oxide film was viewed with a scanning electron microscope. It was observed that the pore diameter was about 20 nm.

Subsequently, the sample was subjected to pore-widening by using the pore-widening apparatus shown in Fig. 4. The sample was immersed for 30 minutes in a 5 percent by weight phosphoric acid aqueous solution controlled at a temperature of 25°C in a constant-temperature oven.

After the sample was taken out, the surface of the anodic oxide film was viewed with a scanning electron microscope. It was observed that the pore diameter was about 100 nm.

The anodic oxide film was cut perpendicularly with a focused ion beam, and the cross-sectional shape of the pore was viewed with a scanning electron microscope. It was observed that the diameter of the pore was substantially uniform in the depth direction.

As described above, in Specific example 1, the anodizing step and the pore-widening step are repeated alternately and, thereby, the pore diameter of the pore can be varied in the depth direction, in contrast to Comparative example 1. In this manner, a microstructure applicable to a higher-performance device can be provided.

SPECIFIC EXAMPLE 2

Specific example 2 of the method for manufacturing a microstructure according to the present invention will be described below.

The anodizing step and the pore-widening step were repeated 10 times with fragmentary operation times, and the cross-sectional shape was observed.

A sample similar to that in the above-described Specific example 1 was prepared, and the conditions other than the treatment time were set similarly to the conditions in Specific example 1. The anodization time and the pore-widening time were set to be one-fifth the predetermined time shown in Specific example 1.

After the anodizing step and the pore-widening step were repeated 10 times alternately, the surface of the anodic oxide film was viewed with a scanning electron microscope. It was observed that the intervals of the pores were about 300 nm.

The anodic oxide film was cut perpendicularly with a focused ion beam, and the cross-sectional shape of the pore was viewed with a scanning electron microscope. It was observed that the pore diameter was decreased smoothly in the depth direction, as in the above-described Fig. 2C, the pore diameter was about 200 nm at the mouth and about 20 nm at the bottom and, therefore, the diameter at the mouth was large as in the tapered shape shown in Fig. 2C.

In the present invention, the ratio of the pore diameter r1 at the mouth to the pore diameter r2 at the bottom can satisfy $r1/r2 \geq 5$. In the present embodiment, since r1 = 200 nm and r2 = 20 nm, r1/r2 = 10 holds and, therefore, $r1/r2 \geq 5$ is satisfied.

This is so that, in the case where the fine structure grating of Specific example 2 is produced by using the nanostructure shown in Fig. 2C as a mold, the fine structure grating can be released from the mold with relative ease.

SECOND EMBODIMENT

An embodiment is described, in which the fine structure grating produced by using the nanostructure of the first embodiment (Specific example 1 and Specific example 2) is applied to the surface of a scanning lens (imaging optical element) of an optical scanning apparatus used for an image forming apparatus, e.g., a laser beam printer or a digital copier.

Examples of techniques for transferring a fine structure grating from the nanostructure include for example the methods of injection molding, press molding, replication, electrolytic deposition, and imprinting. However, injection molding, press molding, and replication are particularly desirable since the fine structure grating can be produced together with a base material.

In the present embodiment, an example in which the application is performed by injection molding as a manufacturing means for a scanning lens (imaging optical element) is described.

A mold having a free-form surface (lens surface) to mold a scanning lens (imaging optical element) was prepared. Uniform films of a primer layer and then an aluminum layer were formed on the free-form surface by sputtering, so that a free-form surface covered with aluminum was produced.

A positive electrode was attached to a part of surfaces other than the free-form surface, and the entire mold was covered with a masking tape to expose the free-form surface only, so that those other than the free-form surface were brought into an insulating waterproof state.

Subsequently, the aluminum film was anodized by one-half the film thickness, and was dissolved to increase the pore diameter of the pore. The remaining aluminum film was anodized again, and the pore diameter was increased again, so that pores having the pore diameter decreased stepwise were formed on the mold surface.

In the anodization, the film was immersed together with a negative electrode in a 5 percent by weight phosphoric acid aqueous solution controlled at a temperature of 10°C, and the direct-current voltage of 120 V was applied for a predetermined time, so that pores were formed up to about one-half the thickness of the aluminum film.

The pore diameter was increased to about 100 nm by immersion in a 5 percent by weight phosphoric acid aqueous solution to effect etching.

The film was immersed again together with the negative electrode in the 5 percent by weight phosphoric acid aqueous solution controlled at a temperature of 10°C.

The direct-current voltage of 120 V was applied and energization continued until the passage of current became sufficiently feeble, so that the second stage pores were formed.

Thereafter, immersion in a 5 percent by weight phosphoric acid aqueous solution at room temperature was performed to effect etching. Consequently, pores were produced on the mold surface in such a way that a pore having a diameter of about 100 nm was formed stepwise at the bottom of each pore having a pore diameter of about 200 nm.

The mold produced by the above-described procedure was placed on each of the incident surface side and the exit surface side, and a cycloolefin polymer (produced by ZEON Corporation) was injection-molded with an injection molding machine (SS180: produced by Sumitomo Heavy Industries, Ltd.), so that a scanning lens was produced.

At this time, the temperature of a molten resin was set at 270°C, and the pressure was kept at 700 kg/cm$^2$ during injection of the resin. When the resin was released from the mold, the releasing was performed so that the resin (fine structure grating) filled in the pores was able to elastically deform.

The incident surface of the thus produced scanning lens was viewed with a scanning electron microscope. It was observed that fine structure gratings were randomly disposed all over the free-form surface and the diameters were decreased in two steps.

It was ascertained that an individual lattice (projection) stood in the direction of the normal of the surface at an interval of about 300 nm.

P-polarized laser beam with a wavelength of 780 nm was incident perpendicularly on the scanning lens and the reflectance was measured. It was observed that the reflectance was reduced to one-quarter the reflectance of a mirror-finished surface with no fine structure grating.

In the second embodiment, fine structure gratings 108 are disposed on the surfaces of the scanning lens (imaging optical element) in order to prevent reflection of the light beam incident on the scanning lens (imaging optical element).

In recent years, scanning lenses (imaging optical elements) of scanning optical systems are generally produced from plastic since aspherical shapes are easily configured and are manufactured easily.

However, with plastic lenses it is difficult to apply an antireflective coating to the lens surface for reasons of technology and cost. Therefore, Fresnel reflection occurs at each lens surface.

Consequently, in the second embodiment, the fine structure gratings 108 are disposed on the incident surface and the exit surface of the scanning lens (imaging optical element).

In the present specification, a direction in which a light beam is reflected and deflected (deflected and scanned) by a deflection device is defined as a main scanning direction, and a direction orthogonal to the optical axis of an imaging optical system and the main scanning direction is defined as a subscanning direction.

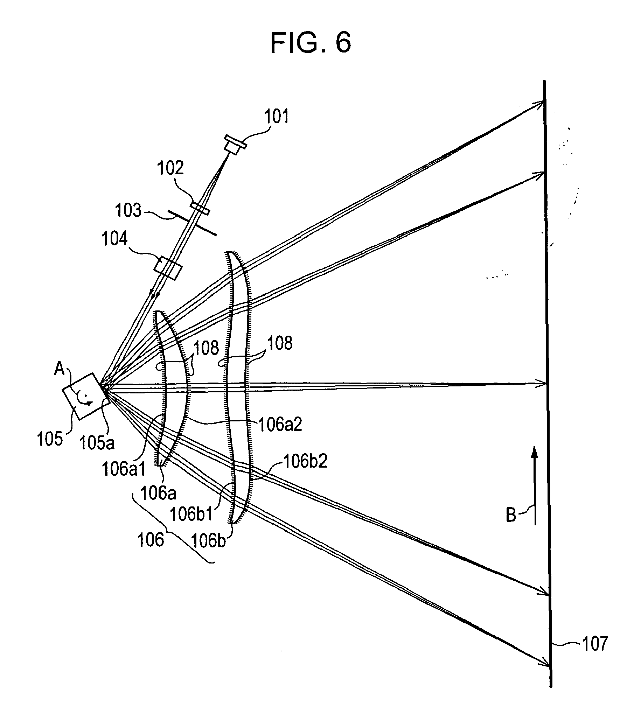

In Fig. 6, reference numeral 101 denotes a light source device composed of, for example, a semiconductor laser. Reference numeral 102 denotes a condenser lens (collimator lens) for converting a divergent light beam emitted from the light source device 101 into a substantially collimated light beam or a convergent light beam.

Reference numeral 103 denotes an aperture stop for shaping a beam shape by regulating the passage of the light beam.

Reference numeral 104 denotes a cylindrical lens that has a predetermined power in only the subscanning direction and forms an image of the light beam passed through the aperture stop 103 on a deflection surface (reflection surface) of an optical deflector 105, described below, as a substantially linear image in a subscanning cross-section.

Reference numeral 105 denotes the optical deflector serving as a deflection device. The optical deflector 105 is composed of, for example, a polygon mirror having a tetrahedral arrangement (rotating polyhedral mirror), and is rotated by a driving device, e.g., a motor (not shown in the drawing) at a constant rate in a direction indicated by an arrow A in the drawing.

Reference numeral 106 denotes an image formation lens system serving as an imaging optical system having a beam-focusing function and fθ characteristics, and including two scanning lenses (imaging optical elements), that is, a first scanning lens 106a and a second scanning lens 106b, made of a plastic material (transparent resin material).

The light beam that is based on image information and reflected and deflected by the optical deflector is made to form an image on the surface to be scanned 107. In addition, a function for compensating for tilt is provided by establishing a conjugated relationship between the deflection surface 105a of the optical deflector 105 and the surface to be scanned 107 in the subscanning cross-section.

In general, a photosensitive drum is disposed on the surface to be scanned.

The light beam from the light source device 100 may be incident directly on the optical deflector 105 without using the above-described optical elements 102, 103, and 104.

Each of the lens surfaces of the two scanning lenses, that is, the first and second scanning lenses 106a and 106b, is in the shape of a spherical or aspherical curved surface in the main scanning cross-section shown in Fig. 6.

Each of the lens surfaces of the two scanning lenses, that is, the first and second scanning lenses 106a and 106b, is basically in the shape of a known special aspherical surface having a curvature varying as the position changes from an on-axis position (center of scanning) in an off-axis position (periphery of scanning) in the subscanning cross-section.

In the second embodiment, fine structure gratings 108 are disposed all over the incident surface (the surface nearest to the optical deflector) 106a1 and the exit surface 106a2 of the first scanning lens and the incident surface 106b1 and the exit surface (the surface nearest to the surface to be scanned 107) 106b2 of the second scanning lens.

These fine structure gratings 108 are configured to perform an antireflective function in accordance with the incident angle of the light beam incident on the scanning lens, so that the reflected beam from the lens surface of the imaging optical system 106 is restricted to become incident on the surface to be scanned 107.

In the present invention, as described in the second embodiment, the fine structure grating including periodically arranged projections of nanometers (nm) produced by using the nanostructure of Specific example 1 and Specific example 2 (shown in Figs. 2A to 2C) is applied to the scanning lens. Therefore, an excellent antireflective property is achieved.

The shape of the fine structure grating is a shape in which the diameter is decreased in the height direction.

While the present invention has been described with reference to exemplary embodiments, it is to be understood that the invention is not limited to the disclosed exemplary embodiments. The scope of the following claims is to be accorded the broadest interpretation so as to encompass all modifications, equivalent structures and functions.

**Claims**

1. A method for manufacturing a nanostructure, the method comprising the steps of:

   a) an anodizing step of anodizing Al or an Al alloy to form an anodic oxide film having first pores,
   b) an increasing step of increasing diameters of the first pores in the anodic oxide film, and
   c) an anodizing step of anodizing the anodic oxide film to form a second pore at the bottom of each first pore, wherein the second pores have different diameters to the first pores.

2. The method for manufacturing a nanostructure according to claim 1, further comprising the step of repeating the steps a), b) and c) at least once.

3. The method for manufacturing a nanostructure according to Claim 1, wherein the diameters of the pores decrease between the first and second pores in the depth direction from the nanostructure surface.

4. The method for manufacturing a nanostructure according to Claim 3, wherein the diameter decrease is stepwise.

5. The method for manufacturing a nanostructure according to Claim 3, wherein the diameter decrease is tapered.

6. The method for manufacturing a nanostructure according to any one of Claims 1 to 5, wherein intervals between the pores are controlled by adjusting the composition, the temperature, and the applied voltage of an acidic electrolytic solution used in the anodizing step.

7. The method for manufacturing a nanostructure according to any one of Claims 1 to 6, wherein the diameters of the pores are controlled by adjusting the composition, the temperature, and the treatment time of an etching solution used in the increasing step.

8. The method for manufacturing a nanostructure according to any one of Claims 1 to 6, wherein the acidic electrolytic solution and the etching solution are phosphoric acid.

9. A nanostructure manufactured by the manufacturing method according to any one of Claims 1 to 8.

10. A method for manufacturing a mold for molding a scanning lens, the method comprising the step of producing a nanostructure on a mold surface in the shape of a curved surface by the manufacturing method according to any one of Claims 1 to 8.

11. A fine structure grating produced using a nanostructure manufactured by the manufacturing method according to Claim 9.

12. A scanning lens produced using a mold manufactured by the manufacturing method according to Claim 10 and comprising the fine structure grating on a lens surface.

13. An optical scanning apparatus comprising a scanning lens according to Claim 12 and an imaging optical system to direct a light beam reflected from an optical deflector to a surface to be scanned.

14. An image forming apparatus comprising an optical scanning apparatus according to Claim 13 and a photosensitive drum disposed on the surface to be scanned.

FIG. 1A

(ANODIZING STEP)

FIG. 1B

(PORE-WIDENING STEP)

FIG. 1C

(ANODIZING STEP)

FIG. 1D

# FIG. 2A

D

3

2

1

# FIG. 2B

D

3

2

1

# FIG. 2C

D

3

2

1

# FIG. 3

# FIG. 4

## FIG. 5

# FIG. 6